# EUROPEAN PATENT APPLICATION

(11) **EP 0 567 419 A2**
(43) Date of publication of application: **27.10.1993**
(21) Application number: 93480023.6
(22) Date of filing: 09.03.1993
(51) Int. Cl.: G03F 1/14

(54) **A shifter-based rim phase shifting structure and process to fabricate the same**

(30) Priority: 23.04.1992 US 872781
(71) Applicant: International Business Machines Corporation, Armonk, N.Y. 10504 (US)
(72) Inventor: Burn, Jeng Lin, Austin, Texas 78749 (US)
(74) Representative: Klein, Daniel Jacques Henri

(57) **Abstract**

This is a method for self-aligned fabrication of a rim phase-shifting mask wherein the blocker (11) is located above the phase-shifting layer (12). Four processes for forming the mask are described : (a) a single layer of resist employing two levels of exposure is used to differentially remove the phase shifter and blocker in separate self-aligned steps ; (b) an organic or inorganic T-structure is produced to achieve the same ; (c) a sidewall structure is used ; and (d) a thin inorganic layer on the phase shifter is used in conjunct on with (a), (b), or (c) above.

## Description

This invention relates to masks for lithography and more particularly to photolithographic phase-shift masks.

In photolithography, masks are employed to expose a pattern upon a work piece. As manufacturing requirements call for exposure of patterns with smaller and smaller dimensions, it is becoming necessary to employ techniques which permit enhancement of the current performance of the process of photolithography. One trend has been to use electromagnetic energy with shorter wavelengths in the UV wavelengths, x-rays and the like. An alternative approach is to use phase-shifting techniques in the ranges of wavelengths used in photolithography in the past.

The phase-shifting technique can improve the resolution of coherent or partially coherent optical imaging systems. It has been shown that the normalized resolution k₁ can be reduced from 0.7 µm to 0.35 µm to improve lithography by two generations.

Use of phase-shifting techniques with masks in optical microlithography systems has been shown to improve projected images. These phase-shifting techniques have been practiced in various configurations.

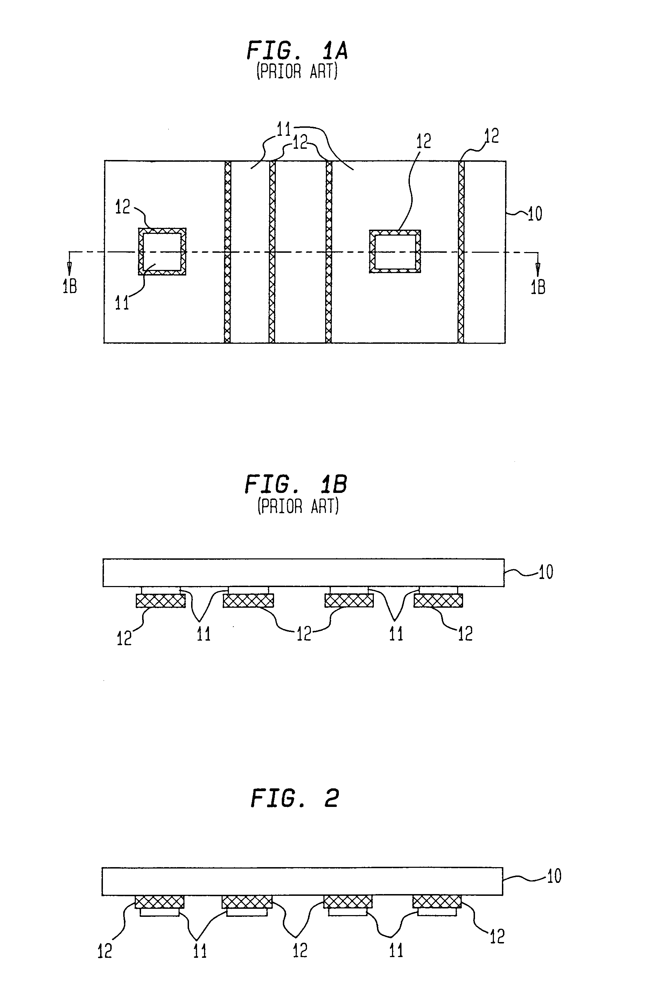

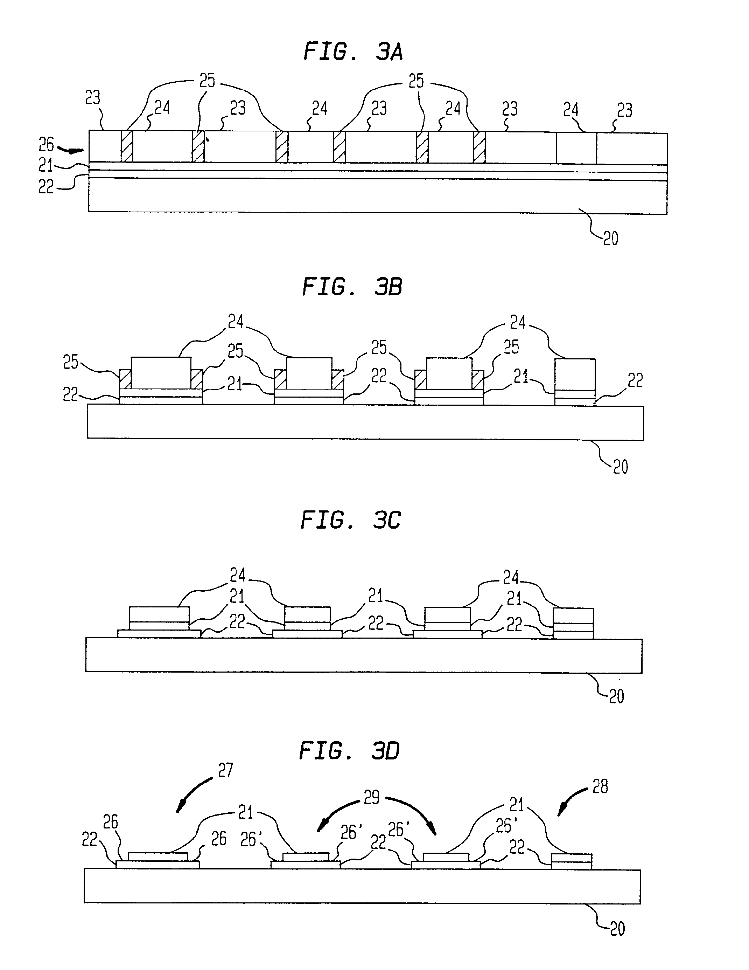

Nakagawa et al "Fabrication of 64M DRAM with i-Line Phase-shift Lithography", IEDM 90, pages 817-820 (1990) shows in FIGS. 2(a) and (b) and 3(a) the mask of blocker layer below a phase shift layer, with a chromium blocker having narrower dimensions than the phase shift layer.

Nitayama et al, "New Phase Shifting Mask with Self-Aligned Phase Shifters for Quarter Micron Photolithography", IEDM Technical Digest, pp. 57-60 (1989) shows a mask pattern consisting of a phase-shifting layer and a slightly smaller opaque layer which blocks tight at the center of the mask pattern as shown in FIG. 1 herein, described below.

Levenson et al, "Improving Resolution in Photolithography with a Phase-Shifting Mask", IEEE Transactions on Electron Devices, Vol. ED-29, No. 12, pp1828-1836, (Dec. 1982) describes alternating element phase-shifting.

Teresawa et al, "0.3-Micron Optical Lithography Using a Phase-Shifting Mask", IEEE Trans. Electron Devices, Vol. 1088, pages 25-33 (1989) describes subresolution phase-shifting which is applicable to closely packed openings or isolated openings respectively.

US-A-No. 5 045 417 of Okamoto for "Mask for Manufacturing Semiconductor Device and Method of Manufacture Thereof' shows (in FIG. 12 thereof) a synthetic quartz glass substrate (2) covered with a metal layer (3) (described as Embodiment4 in Col. 13, lines 28-62.) A phase-shifting groove (7b) of depth (d) is shown in tne quartz glass adjacent to openings in the metal layer (3.)

US-A-No. 4 806 442, "Spatial Phase Modulating Masks and Production Processes Thereof, and Processes for the Formation of Phase-Shifted Diffraction Gratings" describes in the Abstract "Spatial phase modulating transparent masks comprising two or more portions having two different optical paths and their production processes..." See Col. 1, lines 8-14; Col. 3, lines 21-35 and lines 59-66; Col. 4, lines 1-8 and lines 26-41; Col. 9, lines 3-20; and Col. 11, line 10 to Col. 12, line 29 et seq.

US-A-No. 4 885 231, Chan, for "Phase-Shifted Gratings by Selective Image Reversal of Photoresist", Col. 3, lines 21-30.

US-A-No. 4 890 309 of Smith et al for "Lithography Mask with -Phase Shifting Attenuator", See Ab- stractand Col. 1, lines 36-45, Col. 3, lines 18-21, lines 35-38; Col. 5, line 39-40, lines 49-55, lines 64 et seq.

US-A-No. 4 902 899, of Lin et al, for "Lithographic Process Having Improved Image Quality", See abstract and Col. 5, lines 5-8 and lines 15-20.

US-A-No. 4 947 413, Jewell et al, "Resolution Doubling Lithography Technique", See the Abstract; where it is stated, "A spatial filter, positioned to intercept the Fraunhofer diffraction pattern of the mask being exposed is configured to prevent certain orders of the diffraction pattern..."; and Col. 2, lines 53-60 where it is stated "...an aperture filter is located at the position within the system where the Fourier transform (Fraunhofer diffraction pattern) of the mask will appear (within the projection lens system positioned above the wafer). In one embodiment, the filter is configured to block the zero-order (undiffracted) radiation diffracted by the mask into the lens system."
FIGS. 1A and 1B show a prior art rim phase-shifting mask.
FIG. 2 shows a modification of the prior art design of FIG. 1 in accordance with this invention.
FIGS. 3A-3D show a process of fabrication of the shifter-based rim phase-shifting mask using a two-level exposure in accordance with this invention.
FIGS. 4A-4D show the process of fabrication of a capped resist structure with a Blocker-on-Shifter mask using T-shaped etch masks in accordance with this invention.
FIGS. 5A-5F show a side-wall deposition process is an alternative to the above-described processes, in accordance with this invention.
FIGS. 6A-6E show a process of providing a mask in accordance with this invention starting with a thin inorganic material deposited on the absorber before the resist coating, which lies on top.

The configuration of a prior art type of rim phase-shift-ing mask of Nitayama et al, above, is shown in FIGS. 1A and 1 B, where a given mask pattern consists of a substrate 10 carrying a phase-shifting layer 12 and a slightly smaller opaque layer 11 which blocks light at the center of the mask pattern. FIG. 1A is a top view of the mask and FIG. 1 Bis a schematic sectional view taken along line 1 B-1 B in FIG. 1A. This arrangement lends itself to strong enhancement of edge contrast due to the phase-shifting, yet prevents a large negative amplitude at the center of patterns to form ghost lines.

In addition, the phase-shifting effect is generally applicable to any given pattern shapes. This is more preferable than alternating-element phase-shifting of Levenson et al, above, or subresolution phase-shifting of Terasawa et al, above, which is applicable to closely packed openings or isolated openings respectively. However, the configuration of FIGS. 1A and 1B is difficult to practice. The prior art Nitayama et al, above, teaches delineation of the phase-shifting layer on top followed with a self-aligned overetch of the blocking layer. The undercutting dimension and profile are difficult to control forthe precision required to maintain linewidth control.

FIG. 2 is a similar view to FIG. 1 B with a modification of the prior art design of FIGS. 1Aand 1B in accordance with this invention. In FIG. 2, the phase-shifting layer 12 is the base of the blocking layer 11. This configuration facilitates a better process of fabrication to control the profile and dimensions of the blocking pattern. In addition, it also allows inclusion of phase repair layers as described in copending application entitled "A Mask Structure and Process to Repair Missing or Unwanted Phase Shifting Elements", filed at EPO on March 1993 (Fl 9 91 119). Furthermore, contacting the phase shifters to the substrate 10 reduces multiple reflections at the interfaces.

Descriptions of three methods of fabricating the shifter-based (SB) rim phase-shifting (PS) mask of FIG. 2 are described below.

### 1. Two-level Exposure

FIGS. 3 A-3D show the process of fabrication of the shifter-based rim phase-shifting mask using a two-level exposure. To start with in FIG. 3Asubstrate 20 is coated with a phase-shifter layer 22, coated in turn with a blocker layer 21, in turn coated with an undeveloped resist layer 26, which has been exposed through a mask, (not shown), which provides three levels of exposure, i.e exposed, partially exposed and unexposed. The unexposed resist 23, fully exposed resist 24 and partially exposed resist 25. The resist layer 26 is exposed at full dosage at the transparent non-phase-shifted area of the mask and partially exposed at the rim area.

After normal development, in FIG. 3B only the non-phase-shifted area is cleared. All of the fully exposed resist 24 and a fraction of the partially exposed resist 25 on the sides of the fully exposed resist 24 is removed by development of the resist. Then in an etching step using resist 24 and 25 as the etch mask, areas of the blocker layer 21 and the phase shifter 22 beneath the exposed resist is removed thereby delineating features by etching.

Then in FIG. 3C, the remaining unexposed resist 24 of resist 26 is further developed to clear away the remnants of the partially exposed resist 25 leaving exposed surfaces of the etch blockers 21, which are in turn etched away selectively where they are not protected by the fully exposed resist 24. A selective etch which does not attack the phase shifter layer 22 is used so that portions of phase shifter layer 22 extends beyond the periphery of the blocker layer 21.

In FIG. 3D, the remaining resist 24 of layer 26 is stripped until there is no more resist thereby completing the fabrication process. The resulting structure is a set of three types of structures 27, 28 and 29. Structures 27 are wide phase shifters with broader phase-shifting layers 22 with ledges 26 at the rims of blocker 21 on layer 22 uncovered where the blocker material 21 on the central portions of structures 27 have been removed at the rims of structures 27. In the case of the non-phase-shifting structure 28, no ledges 26 exist. Thus no phase shift can be caused by structure 28. In the case of structures 29, the phase shifter areas 22 are narrower and so are the blockers 21, so the narrower ledges 26' about the rims of structures 29 are there to provide phase-shifting by a narrower structures 29.

These structures are produced by programming the partial exposure at the locations requiring the rims with exposed ledges 26. Note that the ledges 26 at the rims do not have to be equal in width. The three different placements of exposure facilitate making of ledges 26, 26' (or none) at the rims, (with the ledges being of unequal width), but still retain the self-aligned property.

### 2. Capped Resist Process

FIGS. 4A-4D show the process of fabrication of a capped resist structure with a Blocker-on-Shifter mask using T-shaped etch masks.

In FIG. 4A, a substrate 30 is shown coated with a layer of phase shifter 32 coated in turn with a layer of blocker 31, showing the mask substrate before patterning.

FIG. 4B shows etch masks produced. After FIG. 4A a step of coating with a second-etch mask resist 34 and a first-etch mask resist 36 is provided. The Portable Conformable Masking (PCM) resist system or PMMA-on- terpolymer resist system is used in place of the two levels of exposure of resist as in FIGS. 3A-3D. This process is described in "Introduction to Microlithography", Edited by L.F. Thompson, C.G. Willson and M.J. Bowden, ACS Symposium Series 219, Ch. 6 (1963). The two layers of resist 36 and 34 are exposed to a single patterning exposure (not shown.) The T-shaped cross section seen in FIG. 4B with layer 36 to cantilevered over the rim of layer 34 at the margins is obtained by differential development of the two resist layers. Then the first-etch mask 36 provides a etch mask for an anisotropic etch to leave portions of layers 32 and 31 extending beyond the edge of second-etch mask 34.

The T-top technique is not limited to PCM or PMMA-on-terpolymer above. Any well known technique to produce an organic or inorganic T-top structure can be used.

FIG. 4C shows the first-etch mask 36 removed so that the anisotropic etch removes exposed portions of the blocker 31, leaving exposed ledges of shifter 32 extending beyond blocker 31 at the rim of blocker 31.

FIG. 4D shows the selective etch blockerwith the second-etch mask 34 removed by means of a step of resist stripping. What is left is the blocker 31 on top of phase-shifters 32. The exposed ledges 36 of the rim of phase shifter 32 are identical in size whereas the ledges 26 and 26' in FIG. 3D are different in size.

### 3. Side-Wall Deposition

Aside-wall deposition process as shown in FIGS. 5A-5F is an alternative to the above-described processes.
FIG. 5A shows a mask substrate with substrate 50, shifter 52, blocker 51 and first-etch mask 54 (of photoresist) before patterning.
FIG. 5B shows the result after the first-etch mask of FIG. 5A as delineated from exposure of the mask to form the pattern of elements 57 from mask 54.
FIG. 5C shows the result after a conformal deposition of the second-etch mask 59 has taken place leaving a pattern of elements 58 above elements 57 in the same shape but with larger dimensions in accordance with the snowfall pattern of increasing dimensions over objects covered by uniform layers on a generally planar substrate.

The second-etch mask 59 can be CVD oxide or a conformally coated polymer.

A uniform anisotropic etch back of the conformally deposited second-etch mask 59 in FIG. 5D leaves only the borders 59' of resist 59. The blockers 51 and shifters 52 are now exposed to be etched resulting in the formation of self-aligned sidewalls 60 of shifters 52 with well controlled thickness.

With both etch mask borders 59' removed by a stripping the second-etch mask 59 resulting in the structure of FIG. 5E (i.e. the remainder of the second-etch mask 59 is removed) ledges 61 are left on the top the margins of the blockers 51 which at this pointcov- er every inch of the surface of the shifters 52. The blockers 51 are etched selectively where ledges 61 are located after the self-aligned second-etch mask 59 is removed.

The first etch mask 54 is removed after the process of FIG. 5E is completed. Mask 54 is made of silicon or polysilicon.

As a result of the etching of ledges 61, the blockers 51 are inset from the walls of the shifters 52 in FIG. 5F.

### 4. Inorganics on absorber

A thin inorganic material deposited on the absorber before resist coating can be used to broaden the choice of processes 1 to 3 above. The task of delineating the absorber and a relatively much thicker phase shifterwithout having to realign is now reduced to delineating only two thin layers. The image in these two thin layers is then used to delineate the phase shifter. The two-level exposure process is now used to teach the concept.

FIG. 6A shows the mask substrate 60 consisting of a resist layer 61, a thin inorganic layer 62 and an absorber layer 63 deposited on the substrate 60 in reverse order as will be well understood by those skilled in the art. The material of the thin inorganic layer 62 can be aluminum, S₁₃N₄, or many others, as will become clear in the following teachings. The resist layer 61 receives the programmed three levels of exposure as before, with areas 64 partially exposed and areas 65 unexposed.

The aluminum/absorber stack 62/63 is delineated using the resist image developed during the first development time as shown in FIG. 6B.

Then the resist 61 is further developed to open the partially exposed areas 64 (leaving unexposed resist65) and the aluminum (inorganic) layer62 is delineated using the new resist image, resulting in a self-aligned smaller aluminum image formed from inorganic layer 62 above the absorber image 63 as shown in FIG. 6C.

The absorber layer 63 is used as the etch mask for the phase shifter 66 which, in this case, is simply an etched step formed in the substrate 60, as shown in FIG. 6D and FIG. 6E where the step is made more visible.

The absorber layer 63 in areas to be exposed at the rims of layer 63 is now opened with the aluminum layer 62 used as a mask to finish the fabrication process, resulting in the structure shown in FIG. 6E.

The technique of carving the phase shifter from the substrate also applies to the situation of FIGS. 3, 4 and 5.

### Process Chemistry

The absorber etchants or a mixture of the absorber and the aluminum etchant can be used to wet etch the stack of the inorganic layer 62 and absorber layer 63 to result in FIG. 6B. Then, the aluminum etchant is used after developing the partially exposed areas to produce the result of FIG. 6C. The resist 65 can now be stripped and the phase shifter66 can be etched with an anisotropical etch process using the image of absorber 63 as the etch mask. The absorber layer 63 on the rim shifters can be removed with the aluminum inorganic layer 62 as a mask.

Si₃N₄ is another material that can be selectively etched from quartz substrate and can mask the etching of the absorber. It can readily substitute aluminum in this application. In either case, there is no need to remove the inorganic layer after the absorber on the rim is removed.

## Claims

1. A method forming a lithographic phase shift mask including
a) starting with a material composed of
i) a phase shifter layer deposited on a substrate,
ii) a blocker layer on said phase shifter layer,
iii) providing a set of double resist structures for protecting said blocker,
b) employing said set of double resist structures to provide a pair of masks for protecting said blocker during forming of the periphery of said shifter layer and then exposing the margin of said blocker,
c) etching away said periphery of said blocker, whereby said blocker covers the central areas of said shifter layer.

2. A method forming a lithographic phase shift mask including
a) starting with a material composed of
i) an absorber/blocker layer deposited on said substrate,
ii) an inorganic layer deposited on said absorber/blocker layer,
iii) a resist layer deposited on said
b) providing a set of variably exposures to said resist layer to provide a pair of resist masks on one level for protecting said inorganic layer during forming of the periphery of said absorber/blocker layer
c) then removing partially exposed resist to expose the margin of said inorganic layer,
d) etching away said periphery of said inorganic layer exposing the margin of said blocker,
whereby said blocker covers the central areas of said shifter layer
e) etching a phase-shifting mask into said substrate without etching said absorber/blocker,
f) etching away the margin of said absorber/blocker.
whereby a phase shifter layer is formed on said substrate.

3. A phase-shifting mask blank consisting of a substrate carrying an inorganic layer on the absorber.

4. A phase-shifting mask blank in claim 3 where said inorganic layer and absorber are deposited on the bulk substrate.

5. A phase-shifting mask blank in claim 3 where the said inorganic layer and absorber are deposited on a phase-shifting layer on the bulk substrate, said phase-shifting layer can be a single layer or a double layer consisting of a phase-shifting layer and an etch stop layer.

6. A phase-shifting mask blank in claim 3 where there are multiple phase-shifting layers or multiple sets of phase-shifting and etch stop layers to facilitate phase-shifting repair.

7. A process of fabrication of a mask comprising
a) creation of a self-aligned inorganic layer and absorber image,
b) self-aligned removal of the inorganic layer at the rim areas,
c) etching of the phase shifter using the absorber image as mask,
d) removal of the absorber at the rim areas.

8. The process of claim 3 wherein said organic layer is aluminum.

9. The process of claim 3 wherein said organic layer in claim 3 is S₁₃N₄.

10. The process of claim 7 in combination with a two-level resist exposure process.

11. The process of claim 7 in combination with a T-structure process.

12. The process of claim 7 in combination with a side- wall deposition process.
